# EUROPEAN PATENT SPECIFICATION

(11) **EP 0 647 023 B1**
(45) Date of publication and mention of the grant of the patent: **30.05.2001**
(21) Application number: 94202844.0
(22) Date of filing: 01.10.1994
(51) Int. Cl.: H03H 11/04

(54) **Method and device for processing signals**
Verfahren und Vorrichtung zur Verarbeitung von Signalen
Méthode et dispositif de traitement de signaux

(30) Priority: 04.10.1993 BE 9301034
(43) Date of publication of application: 05.04.1995
(73) Proprietor: Feremans, Eric Edmond, B-8930 Lauwe (Rekkem) (BE); De Smet, Francis, B-8310 Brugge (BE)
(72) Inventor: Feremans, Eric Edmond, B-8930 Lauwe (Rekkem) (BE); De Smet, Francis, B-8310 Brugge (BE)
(74) Representative: Donné, Eddy

(56) References cited:
- EP-A- 0 497 050
- PATENT ABSTRACTS OF JAPAN vol. 015 no. 106 (E-1044) ,13 March 1991 & JP-A-02 311006 (PIONEER ELECTRON CORP) 26 December 1990,

## Description

The present invention concerns a method and device for processing signals.

In particular, it concerns a method and device for processing audio signals, particularly in order to improve the sound quality and/or to create special effects.

It is known that audio signals can be subject to different types of interferences. An important type of interference hereby is noise. Moreover, various other types of interferences may occur such as distortions which have a negative effect on the sound clarity.

The present invention concerns a method and device for processing signals which makes it possible to significantly improve the sound quality of audio signals, irrespective of the source of the signal to be improved.

A known manner for improvement is disclosed in document JP-A-02 311006. The present invention aims a further improvement.

To this end the invention concerns a method for processing signals, in particular for treating audio signals, whereby an input signal is subjected to a treatment, and whereby said treatment comprises the steps of isolating signals from the input signal, said signals forming a portion of the input signal, which portion represents a predetermined part of the sound frequency range; of forming a signal by generating higher harmonics on the basis of the isolated signals; and of forming an output signal by combining the signal which contains the generated higher harmonics with at least part of said input signal, whereby this input signal was either or not treated before being combined, whereby this method is characterized in that the passage of the signal comprising the generated higher harmonics is controlled as a function of the input signal.

According to a preferred embodiment, in order to produce the signal on the basis of which the higher harmonics are generated, the tones the frequency of which exceed a certain value are isolated and transmitted. The pass limit, in other words the frequency as of which the tones are allowed to pass, is preferably situated between 3000 and 5000 Hz, and better still at about 3 500 Hz.

Moreover, it is preferable that only those tones the frequency of which is situated under a cert in value are isolated, in other words that the tones the frequency of which is situated above said value are eliminated or at least considerably abated. The pass limit, in this case the limit above which the tones are eliminated or considerably abated, is preferably situated between 4 000 and 19 000 Hz and better still at about 7 000 Hz.

According to a special embodiment of the method according to the invention, the input signal is treated before being combined with the signal which consists of the additionally generated higher harmonics. This treatment may consist in that the tones the frequency of which is within a certain range are eliminated and/or abated. Preferably, only tones below the freguency of which is a certain pass limit are let through, whereby this pass limit is preferably situated at about 7000 Hz.

Also, according to the most preferred embodiment, the higher harmonics are generated on the basis of the signals of only a restricted band of the sound range, namely included between 3 500 and 7 000 Hz .

The combination of the signal which produces the additionally generated higher harmonics at the input signal which was either or not treated, in order to provide for the above-mentioned end signal, is preferably realized by supplying both signals to an adder amplifier.

As mentioned above, according to the invention, a control is provided, which consists in that the passage of the additional higher harmonics is regulated as a function of the input signal, or at least as a function of the intensity of said input signal. This control preferably makes it possible for the signal of the additionally generated higher harmonics to be more or less amplified as a function of the input signal.

Depending on the desired effect, different methods can be used with said control. Preferably, the input signal, or at least part thereof, is transformed in a control signal which provides for the required amplification for the signal with the additionally generated higher harmonics. This control signal can be obtained by rectifying the above-mentioned input signal, or a part thereof, and subsequently transforming it into a typical control signal for an amplifier.

The above-mentioned transformation may be carried out according to a mathematical function. Preferably, a linear transformation is provided for.

The above-mentioned control signal does not necessarily have to be based on the entire input signal. Preferably, this control signal is even derived from merely a part of the input signal, in other words a part whose frequencies are situated within a certain range. Preferably, the control signal is derived and/or calculated as a function of the full package of higher tones present in the input signal to be treated, in other words the tones the freguency of which is above a certain pass limit, which is preferably situated between 6 000 and 8 000 Hz, and better still at 7 000 Hz.

The present invention also concerns a device to realize the above-mentioned method.

In order to better explain the characteristics according to the invention, the following preferred embodiments of the invention, in particular of devices according to the invention, are given as an example only without being limitative in any way, with reference to the accompanying figures, where:
figure 1 represents in a block diagram the type of device to which the invention relates ;
figure 2 represents a device according to the invention in a block diagram;
figure 3 represents a diagram which is related to the operation of the device in figure 2.

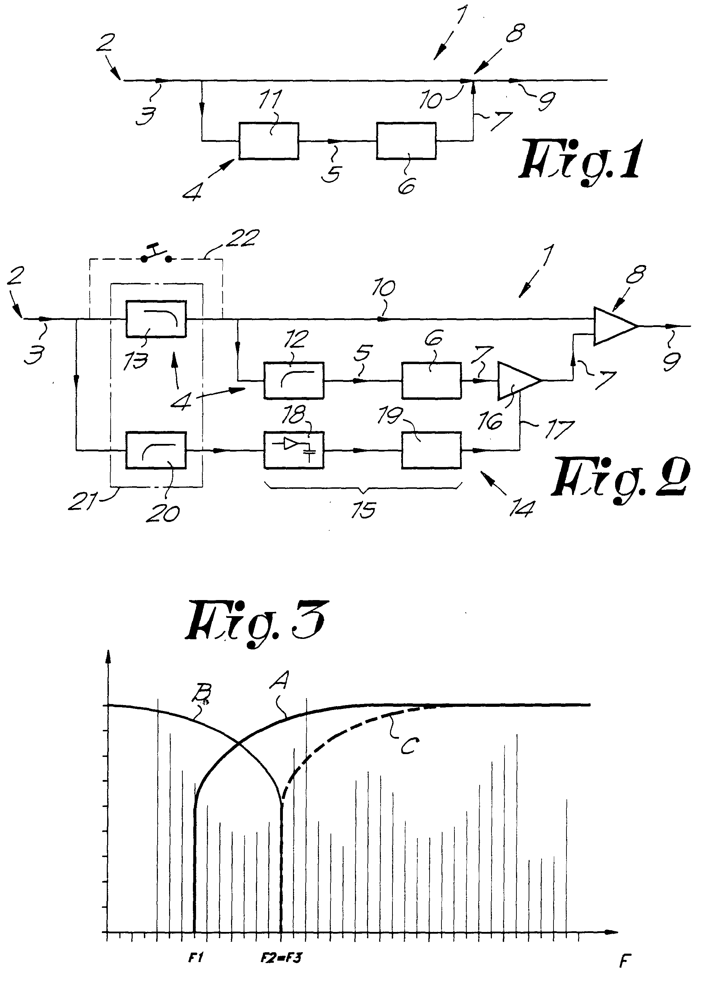

Figure 1 represents an existing principle, more particularly a device 1 for processing audio signals, in particular for improving and/or altering the quality of the sound which results from such signals.

As is also represented in figure 1, the device mainly consists of an entry 2 for the supply of an input signal 3 to be improved and/or altered; means 4 to isolate a number of signals 5 from the input signal 3 which are mainly situated in a specific part of the sound range; means 6 for the additional generation of higher harmonics on the basis of the isolated signals 5, hereafter called signal 7; and means 8 for the formation of an output signal 9 which provide for the combination of the generated higher harmonics, in other words the signal 7, with a signal 10 which is either identical to the input signal 3, or, as will be described hereafter, forms part of the signal 2, either or not in a further treated shape.

The means 4 to isolate a number of signals 5 which are mainly situated in a specific part of the sound range from the input signal 3, consist of a selective element 11 which lets tones within a certain range pass and which eliminates or at least abates the other tones. In preference, a selective circuit is used to this end which eliminates and/or abates at least the lower tones and lets the higher tones pass or lets them pass for the main part, such as for example a high-pass filter or an adjustable selective filter.

In order to obtain an even better effect, the selective element 11 is not only made such that only the lower tones under a certain first pass limit are eliminated and/or abated, but also the higher tones above a second pass limit, whose cutting-off frequency is higher than that of the first pass limit, are eliminated and/or abated.

The values of the above-mentioned pass limits, as preferably used in conjunction with the present invention, will be further elucidated in the description of figures 2 and 3.

The means 6 for the additional generation of higher harmonics on the basis of the isolated signals 5 may consist of a harmonics generator as described in Belgian patent No. 1004054.

The above-mentioned means 8 for the formation of the output signal 9 on the basis of the above-mentioned signals 7 and 10 may be of different nature. In the example given in figure 1, they merely consist of a coupling between the input 2 and the output of the means 6, which implies that the signal 7 is superposed on the input signal 3, which subsequently results in the above-mentioned output signal 9.

Figure 2 represents an embodiment according to the claimed invention. The above-mentioned means 4 consist in this case of two elements of electronic parts 12 and 13.

The element 12 consists of a circuit which eliminates and/or abates the tones under a certain pass limit F1, such as a high-pass filter. The value F1 is preferably situated between 3 000 and 5 000 Hz. In particular, this value F1 preferably amounts to 3500 Hz, as represented by means of the curve A in figure 3. This curve A shows that most tones in the higher range are allowed to pass.

The element 13 consists of a circuit which eliminates and/or abates the tones above a certain pass limit F2, such as a low-pass filter. The value F2 is preferably situated between 6 000 and 19 000 Hz. In particular, this value F2 preferably amounts to 7 000 Hz, as represented by means of the curve B in figure 3. This curve B shows that tones in the lower range are mostly allowed to pass.

The above-mentioned means 6 are of the same nature as in figure 1.

In the embodiment of figure 2, the means 8 consist of an adder amplifier.

As already described in the elucidation of the method, the input signal 3 can be treated first before being supplied, in the shape of a signal 10, to the means 8, in this case the adder amplifier. The treatment preferably consists in that only certain tones are allowed to pass.

In order to reach optimum results with the improvement of existing signals, a circuit is used to this end which eliminates and/or abates the tones above a certain pass limit F3, such as a low-pass filter. The pass limit F3 is preferably situated at 7 000 Hz. In the example represented in figure 2, no separate circuit is used to this end, but the element 13 of the device is also used to this end.

In order to further optimize the aimed effect, the device 1 is provided with an additional control 14, which regulates the transmission of the additionally generated higher harmonics or in other words the signal 7 as a function of certain characteristics of the input signal 3. Preferably, said control 14 makes sure that the signal 7 is amplified to a greater or lesser extent, as a function of the supplied input signal 3 or as a function of a part of this signal, whereby the general intensity of the input signal 3 or of the above-mentioned part thereof is used as a measure for the amplification.

Also, the control 14 mainly consists of a conversion circuit 15 and an adjustable amplifier 16, whereby the amplifier 16 provides for the amplification of the above-mentioned signal 7 and whereby the conversion circuit 15 delivers a control signal 17 which provides for the control of the amplifier 16.

The conversion circuit 15 preferably consists of a rectifier 18 and a transformation circuit 19. The transformation circuit 19 in its turn preferably consists of a linear transformer connection. However, the transformation circuit 19 may also consist of another connection which provides for a transformation according to a mathematical function determined by the designer. According to yet another special embodiment, the transformation circuit 19 is equipped with a threshold connection.

In order to further optimize the aimed effect, only part of the input signal 3 is transmitted to the conversion circuit 15 by making use of a selective element 20 which lets through only the tones above a certain pass limit. This fourth pass limit preferably has a value between about 6 000 and 8 000 Hz, and better still of 7 000 Hz. Use can be made to this end of a high-pass filter. The working of the selective element 20 is represented in figure 3 by means of a curve C.

The above-mentioned part 13 and the selective element 20 may possibly be integrated in one adjustable filter 21.

According to yet another variant, a circuit 22 can be provided to short-circuit the above-mentioned element 13, one and other such that this element 13, if required, can be switched off.

The working of the device 1 can be easily derived from figure 2 and the previous description.

The original audio signal is supplied as input signal 3 to the input of the device 1. This input signal is stripped of part of the top harmonics through the selective operation of the element 13 of the device 1. The resulting signal is led to the element 12, which, as mentioned above, preferably consists of a high-pass filter, which lets part of the remaining harmonics through.

The remaining signal is supplied to the harmonic generator 6, which adds high harmonics to the signal.

The obtained signal 7 is supplied to the adjustable amplifier 16 which in turn transmits an amplified signal to the second input of the adder amplifier 8.

The control voltage of the adjustable amplifier 16 is derived from the input signal 3. To this end, this input signal 3 is supplied to the selective element 20, in this case a high-pass filter which determines whether there are any harmonic components as of the set frequency and transmits them to the conversion circuit 15 which delivers a control signal 17 in the shape of an output voltage as a function of the signal after the rectifier 18, whereby different settings are possible. As mentioned above, a threshold voltage can hereby be set, but also other linear, non-linear and complex relations between the input signal and the output signal of the transformation circuit 19 are possible, such to make an optimum acoustic setting possible.

Thanks to the device 1, the noise of the audio signal is less disturbing and/or the sound is broadened in the audible spectrum.

It should be noted that the method as well as the device 1 reduce the signal/noise relation of audio signals, irrespective of the type of source. Taking into account the psycho-acoustic data, the sound is brightened, in particular provided with extra dominant tones.

It is clear that in this description, by "tones" should usually be understood the electric signals corresponding to these tones.

The device 1 can be made analogous as well as digital.

It should be noted that in the appended claims, the use of the expression "first pass limit", "second pass limit", "third pass limit" or "fourth pass limit" does not implicate the presence of any of the other pass limits.

The present invention is by no means limited to the embodiments described by way of example and represented in the figures; on the contrary, such a method and device for processing signals can be made in all sorts of variants while still remaining within the scope of the invention as defined in the accompanying claims.

## Claims

1. Method for processing signals, in particular for treating audio signals, whereby an input signal (3) is subjected to a treatment, and whereby said treatment comprises the steps of isolating signals (5) from the input signal (3), said isolated signals (5) forming a portion of the input signal (3), which portion has frequencies only within a predetermined part of the sound frequency range; of forming a signal (7) by generating higher harmonics on the basis of the isolated signals (5); and of forming an output signal (9) by combining the signal (7) which contains the generated higher harmonics with at least part of said input signal (3), whereby this input signal (3) was either or not treated before being combined, characterized in that the passage of the signal (7) comprising the generated higher harmonics is controlled as a function of the input signal (3).

2. Method according to claim 1, characterized in that of order to form the signal on the basis of which the higher harmonics are generated, the signals which represent audio tones the frequency of which exceed a first pass limit (F1) are isolated and are allowed to pass.

3. Method according to claim 2, characterized in that said first pass limit (F1), is situated between 3 000 and 5 000 Hz.

4. Method according to claim 3, characterized in that said first pass limit (F1) is 3 500 Hz.

5. Method according to any of claims 2, 3 or 4, characterized in that in order to form the signal on the basis of which the higher harmonics are generated, also the signal representing frequencies which are situated above a second pass limit (F2) are eliminated or at least abated.

6. Method according to claim 5, characterized in that the second pass limit (F2) is situated between 4 000 and 19 000 Hz.

7. Method according to claim 6, characterized in that the second pass limit (F2) is 7 000 Hz.

8. Method according to any of the previous claims, characterized in that the input signal (3) is treated before being combined with the signal (7) which contains the additionally generated higher harmonics, whereby this treatment consists in that signals representing tones within a certain frequency range are eliminated and/or abated.

9. Method according to claim 8, characterized in that during the above-mentioned treatment of the input signal (3) only tones the freguency of which are below a third pass limit (F3) are mainly let through.

10. Method according to claim 9, characterized in that the third pass limit (F3) is 7 000 Hz.

11. Method according to claim 9 or 10 and 5, 6 or 7, characterized in that the third pass limit (F3) in the above-mentioned treatment of the input signal (3) and the second pass limit (F2) have same value.

12. Method according to any of the preceding claims characterized in that the control makes sure that the signal (7) with the additionally generated higher harmonics is more or less amplified as a function of the input signal (3).

13. Method according to any of the preceding claims, characterized in that the above-mentioned control takes place on the basis of a control signal (17) which is derived from the input signal (3), or a part thereof, by rectifying it and subsequently transforming it.

14. Method according to claim 13, characterized in that the transformation is carried out according to a determined mathematical function.

15. Method according to claim 13, characterized in that the transformation consists of a linear transformation.

16. Method according to any of the above claims characterized in that the above-mentioned control is based on merely part of the input signal (3), in particular primarily the part of the signal which represents frequencies which are situated above a fourth pass limit.

17. Method according to claim 16, characterized in that the fourth pass limit is 7 000 Hz.

18. Device for the realization of the method of claim 1, comprising an entry (2) for an input signal (3); means (4) for isolating signals (5) from the input signal (3), said isolated signals (5) forming a portion of the input signal (3), which portion has frequencies only within a predetermined part of the sound frequency range; means for forming a signal (7) by generating higher harmonics on the basis of the isolated signals (5); means for forming an output signal (9) by combining the signal (7) which contains the generated higher harmonics with at least part of said input signal (3), whereby this input signal (3) was either or not treated before being combined, characterized in that the device further comprises a control (14) which controls the passage of the signal (7) comprising the generated higher harmonics as a function of the input signal (3).

## Patentansprüche

1. Verfahren für die Verarbeitung von Signalen, insbesondere für die Behandlung von Audiosignalen, wobei ein Eingangssignal (3) einer Behandlung unterzogen wird und wobei sich diese Bchandlung zusammensetzt aus den Schritten Isolieren von Signalen (5) vom Eingangssignal (3), wobei diese isolierten Signale (5) einen Teil des Eingangssignals (3) bilden, der nur Frequenzen innerhalb eines vorbestimmten Teil des Klangfrequenzbereichs aufweist: Bilden eines Signals (7) durch Erzeugung höherer Obertöne auf der Basis der isolierten Signale (5); und Bilden eines Ausgangssignals (9) durch Kombinieren des Signals (7), das die erzeugten höheren Obertöne enthält, mit mindestens einem Teil des erwähnten Eingangssignals (3), wobei dieses Eingangssignal (3) vor dem Kombinieren behandelt worden ist oder nicht, dadurch gekennzeichnet. dass der Durchlass des Signals (7), das die erzeugten höheren Obertöne umfasst, in Abhängigkeit von dem Eingangssignal (3) gesteuert wird.

2. Verfahren gemäß Anspruch 1, dadurch gekennzeichnet, dass zum Bilden des Signals auf der Basis dessen die höheren Obertöne erzeugt werden, die Signale, die die Audiotöne darstellen, deren Frequenz eine bestimmte erste Durchlassgrenze (F1) überschreiten, isoliert und durchgelassen werden.

3. Verfahren gemäß Anspruch 2, dadurch gekennzeichnet, dass die erwähnte erste Durchlassgrenze (Fl) zwischen 3.000 und 5.000 Hz liegt.

4. Verfahren gemäß Anspruch 3, dadurch gekennzeichnet, dass die erwähnte erste Durchlassgrenze (F1) 3.500 Hz beträgt.

5. Verfahren gemäß irgendeinem der Ansprüche 2, 3 oder 4, dadurch gekennzeichnet, dass zum Bilden des Signals, auf der Basis dessen die höheren Obertöne erzeugt werden, auch Signale, deren Frequenzen über einer zweiten Durchlassgrenze (F2) liegen, eliminiert oder zumindest abgeschwächt werden.

6. Verfahren gemäß Anspruch 5, dadurch gekennzeichnet, dass die zweite Durchlassgrenze (F2) zwischen 4.000 und 19.000 Hz liegt.

7. Verfahren gemäß Anspruch 6, dadurch gekennzeichnet, dass die zweite Durchlassgrenze (F2) 7.000 Hz beträgt.

8. Verfahren gemäß irgendeinem der vorhergehenden Ansprüche, dadurch gekennzeichnet, dass das Eingangssignal (3) behandelt wird, bevor es mit dem Signal (7), das die zusätzlich erzeugten höheren Obertöne enthält, kombiniert wird, wobei diese Behandlung daraus besteht, dass Signale, die Töne innerhalb eines bestimmten Frequenzbereichs darstellen, eliminiert und/oder abgeschwächt werden.

9. Verfahren gemäß Anspruch 8, dadurch gekennzeichnet, dass bei der oben erwähnten Behandlung des Eingangssignals (3) vorwiegend nur Töne durchgelassen werden, deren Frequenz unterhalb einer dritten Durchlassgrenze (F3) liegt.

10. Verfahren gemäß Anspruch 9, dadurch gekennzeichnet, dass die dritte Durchlassgrenze (F3) 7.000 Hz beträgt.

11. Verfahren gemäß Anspruch 9 oder 10 und 5, 6 oder 7, dadurch gekennzeichnet, dass die dritte Durchlassgrenze (F3) in der oben erwähnten Behandlung des Eingangssignals (3) und die zweite Durchlassgrenze (F2) den gleichen Wert haben.

12. Verfahren gemäß irgendeinem der vorhergehenden Ansprüche, dadurch gekennzeichnet, dass die Steuerung sicherstellt, dass das Signal (7) mit den zusätzlich erzeugten höheren Obertönen in Abhängigkeit von dem Eingangssignal (3) mehr oder weniger verstärkt wird.

13. Verfahren gemäß irgendeinem der vorhergehenden Ansprüche, dadurch gekennzeichnet, dass die oben erwähnte Steuerung auf der Basis des Steuersignals (17) erfolgt, das von dem Eingangssignal (3) oder einem Teil davon abgeleitet wird, indem dieses gleichgerichtet und anschließend umgewandelt wird.

14. Verfahren gemäß Anspruch 13, dadurch gekennzeichnet, dass die Umwandlung gemäß einer festgelegten mathematischen Funktion erfolgt.

15. Verfahren gemäß Anspruch 13, dadurch gekennzeichnet, dass es sich bei der Umwandlung um eine lineare Umwandlung handelt.

16. Verfahren gemäß irgendeinem der vorhergehenden Ansprüche, dadurch gekennzeichnet, dass die oben erwähnte Steuerung lediglich auf einem Teil des Eingangssignals (3) basiert, insbesondere vorwiegend auf dem Teil des Signals, der Frequenzen darstellt, die über einer vierten Durchlassgrenze liegen.

17. Verfahren gemäß Anspruch 16, dadurch gekennzeichnet, dass die vierte Durchlassgrenze 7.000 Hz beträgt.

18. Vorrichtung zur Ausführung des Verfahrens gemäß Anspruch 1, bestehend aus einem Eingang (2) für ein Eingangssignal (3); Mitteln (4) zum Isolieren der Signale (5) von dem Eingangssignal (3), wobei diese isolierten Signale (5) einen Teil des Eingangssignals (3) bilden, der Frequenzen aufweist, die nur innerhalb eines bestimmten Teils des Klangfrequenzbereichs liegen; Mitteln zum Bilden eines Signals (7) durch Erzeugung höherer Obertöne auf der Basis der isolierten Signale (5); Mitteln zum Bilden eines Ausgangssignals (9) durch Kombinieren des Signals (7), das die erzeugten höheren Obertöne mit zumindest einem Teil des erwähnten Eingangssignals (3) enthält, wobei dieses Eingangssignal (3) vor dem Kombinieren behandelt worden ist oder nicht, dadurch gekennzeichnet, dass die Vorrichtung außerdem eine Steuerung (14) umfasst, die das Durchlassen des Signals (7), das die erzeugten höheren Obertöne enthält, in Abhängigkeit von dem Eingangssignal (3) steuert.

## Revendications

1. Procédé pour traiter des signaux, en particulier pour traiter des signaux audio, par lequel on soumet un signal d'entrée (3) à un traitement et par lequel ledit traitement comprend les étapes consistant à: isoler des signaux (5) à partir du signal d'entrée (3), lesdits signaux isolés (5) formant une portion du signal d'entrée (3), ladite portion possédant des fréquences uniquement dans les limites d'une partie prédéterminée de la gamme de fréquences acoustiques; former un signal (7) en générant des harmoniques supérieures sur base des signaux isolés (5); et former un signal de sortie (9) en combinant le signal (7) qui contient les harmoniques supérieurs générés avec au moins une partie dudit signal d'entrée (3), par lequel ce signal d'entrée (3) a été traité où non avant sa combinaison, caractérisé en ce que le passage du signal (7) comprenant les harmoniques supérieurs générés est commandé en fonction du signal d'entrée (3).

2. Procédé selon la revendication 1, caractérisé en ce que, dans le but de former le signal sur la base duquel sont générés les harmoniques supérieurs, les signaux qui représentent des sons audio dont la fréquence dépasse une première limite de passage (F1) sont isolés et sont autorisés à passer.

3. Procédé selon la revendication 2, caractérisé en ce que ladite première limite de passage (F1) est située entre 3000 et 5000 Hz.

4. Procédé selon la revendication 3, caractérisé en ce que ladite première limite de passage (F1) s'élève à 3500 Hz.

5. Procédé selon l'une quelconque des revendications 2, 3 ou 4, caractérisé en ce que, dans le but de former le signal sur la base duquel sont générés les harmoniques supérieurs, on élimine ou au moins on diminue également le signal représentant des fréquences qui sont situées au-dessus d'une deuxième limite de passage (F2).

6. Procédé selon la revendication 5, caractérisé en ce que la deuxième limite de passage (F2) est située entre 4000 et 19 000 Hz.

7. Procédé selon la revendication 6, caractérisé en ce que la deuxième limite de passage (F2) s'élève à 7000 Hz.

8. Procédé selon l'une quelconque des revendications précédentes, caractérisé en ce qu'on traite le signal d'entrée (3) avant de le combiner avec le signal (7) qui contient les harmoniques supérieurs générés en outre, par lequel ce traitement consiste à éliminer et/ou à diminuer les signaux représentant des sons rentrant dans les limites d'une certaine gamme de fréquences.

9. Procédé selon la revendication 8, caractérisé en ce qu'au cours du traitement susmentionné du signal d'entrée (3), on laisse principalement passer uniquement les sons dont la fréquence se situe en dessous d'une troisième limite de passage (F3).

10. Procédé selon la revendication 9, caractérisé en ce que la troisième limite de passage (F3) s'élève à 7000 Hz.

11. Procédé selon la revendication 9 ou 10 et 5, 6 ou 7, caractérisé en ce que la troisième limite de passage (F3) dans le traitement susmentionné du signal d'entrée (3) et la deuxième limite de passage (F2) possèdent la même valeur.

12. Procédé selon l'une quelconque des revendications précédentes, caractérisé en ce que la commande fait en sorte que le signal (7) contenant les harmoniques supérieurs générés en outre est plus ou moins amplifié en fonction du signal d'entrée (3).

13. Procédé selon l'une quelconque des revendications précédentes, caractérisé en ce que la commande susmentionnée a lieu sur base d'un signal de commande (17) qui dérive du signal d'entrée (3) ou d'une partie de ce dernier, en le redressant et en le transformant par la suite.

14. Procédé selon la revendication 13, caractérisé en ce que l'on effectue la transformation conformément à une fonction mathématique déterminée.

15. Procédé selon la revendication 13, caractérisé en ce que la transformation consiste en une transformation linéaire.

16. Procédé selon l'une quelconque des revendications ci-dessus, caractérisé en ce que la commande susmentionnée se base sur simplement une partie du signal d'entrée (3), en particulier principalement sur la partie du signal qui représente des fréquences qui sont situées au-dessus d'une quatrième limite de passage.

17. Procédé selon la revendication 16, caractérisé en ce que la quatrième limite de passage s'élève à 7000 Hz.

18. Dispositif pour la mise en oeuvre du procédé selon la revendication 1, comprenant une entrée (2) pour un signal d'entrée (3) ; un moyen (4) pour isoler des signaux (5) par rapport au signal d'entrée (3), lesdits signaux isolés (5) formant une portion du signal d'entrée (3), ladite portion possédant des fréquences rentrant uniquement dans une partie prédéterminée de la gamme de fréquences acoustiques ; un moyen pour former un signal (7) en générant des harmoniques supérieurs sur la base des signaux isolés (5) ; un moyen pour former un signal de sortie (9) en combinant le signal (7) qui contient les harmoniques supérieurs générés avec au moins une partie dudit signal d'entrée (3), par lequel ce signal d'entrée (3) a été traité ou non avant d'être combiné, caractérisé en ce que le dispositif comprend en outre une commande (14) qui commande le passage du signal (7) comprenant les harmoniques supérieurs générés, en fonction du signal d'entrée (3).
